# EUROPÄISCHE PATENTSCHRIFT

(11) **EP 1 691 424 B1**
(45) Veröffentlichungstag und Bekanntmachung des Hinweises auf die Patenterteilung: **20.06.2012**
(21) Anmeldenummer: 06001792.8
(22) Anmeldetag: 28.01.2006
(51) Int. Cl.: H01L 31/18, H01L 21/67, H01L 31/0224

(54) **Verfahren und Vorrichtung zur Herstellung von Siliziumsolarzellen**
Method and device for fabrication of silicon solar cells
Méthode et dispositif pour la fabrication de cellules solaires en silicium

(30) Priorität: 09.02.2005 DE 102005005808
(43) Veröffentlichungstag der Anmeldung: 16.08.2006
(73) Patentinhaber: centrotherm photovoltaics AG, 89143 Blaubeuren (DE); Universität Konstanz, 78457 Konstanz (DE)
(72) Erfinder: Wandel, Gernot Dr., 89143 Blaubeuren (DE); Wanka, Harald Dr., 89134 Blaustein (DE); Koriath, Jörg Dr., 89143 Blaubeuren (DE); Lenz, Reinhard, 89143 Blaubeuren (DE); Schneider, Andreas Dr., 79271 St. Peter (DE); Peter, Kristian Dr., 78464 Konstanz (DE); Kränzel, Andreas, 78315 Rafolfzell (DE); Pernau, Thomas Dr., 89143 Blaubeuren-Weiler (DE)
(74) Vertreter: Heyerhoff & Geiger

(56) Entgegenhaltungen:
- EP-A1- 1 197 720
- EP-A2- 1 119 007
- JP-A- 2001 091 162
- JP-A- 2001 133 160
- JP-A- 2001 147 083
- JP-A- 2003 261 222
- US-A- 5 118 362

## Beschreibung

Die vorliegende Erfindung betrifft ein Verfahren zur Herstellung von Siliziumsolarzellen für die Umwandlung von Licht in Strom, insbesondere deren Kontaktierung mit elektrischen Kontakten, sowie eine Vorrichtung zur Durchführung des Verfahrens.

Für Solarzellen werden im Allgemeinen dünne Scheiben aus polykristallinem, mit Bor dotiertem Silizium eingesetzt. Üblich sind p-Dotierungen von 10¹⁵ bis 10¹⁷ Ladungsträgern /cm³. Die Dicke derartiger Scheiben beträgt zwischen 50 und 500 *µ*m. Die Kantenlänge der üblicherweise quadratischen, pseudoquadratischen oder rechteckigen Scheiben beträgt gegenwärtig 100 bis 210 mm.

In die p-dotierten Siliziumscheiben werden auf der Vorder- und Rückseite oder vorwiegend einseitig Phosphoratome eindiffundiert, so dass in einer Oberflächenschicht von weniger als 1 *µ*m Dicke, typischerweise ca. 0,5 *µ*m, eine hohe n-Dotierung von einigen 10¹⁹ bis einigen 10²⁰ Phosphoratomen pro cm³ entsteht. Der so erzeugte p-n-Übergang bewirkt in der späteren Solarzelle die Ladungsträgertrennung.

Auf die zu beleuchtende "Vorderseite" der Siliziumscheibe wird dann zur Erhöhung des Wirkungsgrades der Zelle eine Antireflexschicht aus Siliziumnitrid aufgebracht. Die Dicke der Antireflexschicht beträgt typischerweise 75 nm, insbesondere zwischen 60 und 90 nm. Die Aufbringung der Antireflexschicht erfolgt aus der Gasphase. Als Prozessgas wird vorzugsweise ein Gemisch aus Silan und Ammoniak verwendet. Die Abscheidung erfolgt nach Zündung eines Plasmas unter vermindertem Druck bei Temperaturen von etwa 400°C. Der dabei als Reaktionsprodukt entstehende Wasserstoff diffundiert in die Siliziumscheibe, lagert sich an Gitterstörstellen an und passiviert diese. Gleichzeitig diffundiert der Wasserstoff entlang der Korngrenzen und passiviert diese zusätzlich.

Vorder- und Rückseite der Siliziumscheibe müssen nun mit elektrischen Kontakten versehen werden. Die Rückseite wird im Wesentlichen ganzflächig durch Aufbringung von Aluminium, oder einem anderen geeigneten Metall, die Vorderseite im Wesentlichen streifenförmig mit Silberkontakten versehen. Hierzu werden beide Seiten mit einer entsprechenden Paste aus organischen Bindemitteln und feinteiligen Metallpartikeln üblicherweise im Siebdruckverfahren beschichtet. Nach Ausbrennen der organischen Bestandteile in sauerstoffhaltiger Atmosphäre, insbesondere Luft in einem Ofen, z.B. Durchlaufofen, bei typischerweise ca. 500°C, insbesondere 450 bis 520°C, werden die verbliebenen Metallbestandteile der Paste danach bei 750 bis 900°C mit der Siliziumoberfläche "versintert", wobei auch die Bahnen der Silberbeschichtung durch die Antireflexschicht hindurchsintern. Zum Ausgleich unterschiedlicher Ausdehnungskoeffizienten von Kontaktierungsmetallen und Silizium und zum Anätzen der Siliziumoberfläche wird der Paste ferner eine niedrig schmelzende Glasfritte zugesetzt.

Während des Sinterschrittes laufen verschieden Reaktionen ab. An der Rückseite werden Aluminium und Silizium teilweise miteinander legiert, was sich günstig auf die Solarzellenparameter auswirkt. Andere Reaktionen wirken sich teilweise schädigend aus, wie die unerwünschte Dotierungsumverteilung, insbesondere wird durch Diffusion der Phosphoratome die n-Dotierung verbreitert und der p-n-Übergang abgeflacht. Ferner kommt es zur unerwünschten Ausdiffusion des Wasserstoffs und Depassivierung der Störstellen und zur Eindiffusion von Verunreinigungen.

Um diese negativen Auswirkungen zu minimieren, wird der Sinterschritt in sehr kurzer Zeit durchgeführt. Sowohl die Aufheizung von ca. 500°C auf die Sintertemperatur als auch das Abkühlen nach Sinterung erfolgt in sehr kurzer Zeit, d.h. mit Aufheiz-und Abkühlraten von z.B. 20 bis 40°C pro Sekunde bei einer Haltezeit bei der Sintertemperatur von 5 bis 10 Sekunden als RTP-Prozess (Rapid Thermal Prozessing).

Dennoch weisen die so hergestellten Siliziumwafer noch keine voll befriedigenden Eigenschaften auf. Insbesondere ist die Lebensdauer der Ladungsträger unbefriedigend.

Es wurde nun gefunden, dass die Ladungsträgerlebensdauer in polykristallinem Silizium wesentlich verlängert werden kann, wenn während des schnellen Abkühlens der Wafer beim Durchschreiten des Temperaturbereiches zwischen 550 und 600°C die schnelle Abkühlung für 10 bis 20 Sekunden unterbrochen wird. Dieser Effekt ist zunächst überraschend, da bei diesen Temperaturen und der kurzen Haltezeit wesentliche Ausheilprozesse des Kristallgitters nicht zu erwarten sind. Der Effekt wird daher mit der Existenz des Silizium-Aluminium-Eutektikums der Zusammensetzung 11,3 Atom-% Silizium und 88,7 Atom-% Aluminium mit einer Schmelztemperatur von 577°C in Verbindung gebracht. Es scheint, dass durch zu schnelles Erstarren der Schmelze in der Nähe der eutektischen Zusammensetzung jeweils stark mit Silizium bzw. Aluminium übersättigte spannungsreiche Feststoffphasen entstehen, die zu einer Verbiegung des Wafers führen.

Gegenstand der vorliegenden Erfindung ist dem gemäß ein Verfahren zur Herstellung von Siliziumsolarzellen durch Beschichten von vordotierten Siliziumwafern zumindest einseitig mit einer Aluminiumpaste, Zersetzen der organischen Bestandteile und Kurzzeitsintern bei 700 bis 900°C mit schnellem Abkühlen auf eine Temperatur unter 300°C, das dadurch gekennzeichnet ist, dass das schnelle Abkühlen in einem Temperaturbereich von 550 bis 600°C für 10 bis 20 Sekunden unterbrochen wird.

Vorzugsweise erfolgt die Unterbrechung der schnellen Abkühlung im Temperaturbereich von 560 bis 590°C, insbesondere bevorzugt im Temperaturbereich von 570 bis 580°C.

Die Unterbrechung des schnellen Abkühlens kann dadurch erfolgen, dass in einem Temperaturbereich innerhalb des Bereiches von 550 bis 600°C die Abkühlrate entsprechend herabgesetzt wird, beispielsweise im Temperaturbereich von 550 bis 600°c auf 5 bis 2,5°C pro Sekunde oder im Temperaturbereich von 565 bis 585°C auf 2 bis 1°C pro Sekunde. Die Unterbrechung der schnellen Abkühlung kann erfindungsgemäß auch dadurch erfolgen, dass bei einer Temperatur innerhalb des Temperaturbereiches die Temperatur für einen Zeitraum von 10 bis 20 Sekunden im Wesentlichen konstant gehalten wird.

Die Abkühlung nach dem Sinterschritt erfolgt vorzugsweise bei einer Abkühlgeschwindigkeit von mehr als 20°C pro Sekunde, besonders bevorzugt zwischen 30 und 50°C pro Sekunde bis mindestens herab zu einer Temperatur, bei der im Wesentlichen keine thermischen Prozesse in der Siliziumscheibe mehr ablaufen, vorzugsweise also bis herab auf 300°C, besonders bevorzugt bis 250°C. Weiterhin schnelles Abkühlen ist nicht schädlich, allerdings verlangsamt sich die Abkühlrate wegen der geringeren Temperaturdifferenz zur Raumtemperatur, wenn keine besonderen Maßnahmen zur weiterhin schnellen Abkühlung getroffen werden.

Als vordotierte Siliziumwafer können einkristalline oder polykristalline Siliziumscheiben eingesetzt werden. Bevorzugt sind polykristalline Siliziumscheiben einer Dicke von ca. 50 bis 400 *µ*m.

Vorzugsweise werden Siliziumwafer eingesetzt, die mit 2·10¹⁵ bis 5·10¹⁶ Boratomen pro cm³ dotiert sind und die eine oberflächliche, ca. 0,5 *µ*m tiefe Phosphordotierung von 3·10¹⁹ bis 3·10²⁰ Atomen pro cm³ aufweisen.

Die vordotierten Siliziumwafer sind bevorzugt einseitig mit einer Antireflexschicht aus Siliziumnitrid beschichtet.

Vorzugsweise werden die vordotierten Siliziumwafer rückseitig mit einer aluminiumhaltigen Paste im wesentlichen ganzflächig und auf der anderen Seite, die vorzugsweise die Antireflexschicht aufweist, streifenförmig mit einer silberhaltigen Paste im Siebdruckverfahren beschichtet. Die Pasten bestehen neben den dispergierten Metallpartikeln im Wesentlichen aus organischen Lösungs-, Dispergier- und Bindemitteln. Die Abmessungen der dispergierten Metallpartikel können im µm-Bereich liegen, beispielsweise im Bereich von 1 bis 10 *µ*m. Ferner werden in den Pasten in an sich bekannter Weise feinteilige niedrig schmelzende Gläser mit verwendet. Nach jeder Pastenbeschichtung wird die frische Paste bei ca. 200°C getrocknet.

Gegenstand der Erfindung ist auch ein mehrstufiger Durchlauf-Sinterofen für die Kontaktierung von Siliziumwafern mit folgenden Elementen:
a) eine Sinterzone zur Erreichung einer Temperatur von 700 bis 900°C;
b) eine sich an die Sinterzone anschließende erste Kühlzone zur Abkühlung auf eine Temperatur zwischen 550 bis 600°C;
c) eine sich an die erste Kühlzone anschließende Entspannungszone, eingerichtet zur Aufrechterhaltung einer Temperatur von 550 bis 600°C;
d) eine sich an die Entspannungszone anschließende zweite Kühlzone zur Erreichung einer Temperatur von unterhalb 300°C;
wobei die Länge in Durchgangsrichtung der Entspannungszone das 1,5- bis 4,5-fache der Länge der Sinterzone beträgt; und
wobei die Länge in Durchgangsrichtung der ersten Kühlzone das 0,7- bis 2-fache, vorzugsweise bis 1,2-fache der Sinterzone beträgt.

Die Siliziumwafer werden auf einem geeigneten Durchlauf-Transportmittel, wie beispielsweise einer geeignet angetriebenen Drahtgliederkette, angeordnet, die den Sinterofen in Abhängigkeit von dessen Länge mit konstanter Geschwindigkeit durchläuft, so dass jeder Wafer sich entsprechend dem Längenverhältnis der Ofenzonen für die nach dem erfindungsgemäßen Verfahren erforderlichen Zeiten in den einzelnen Ofenzonen befindet bzw. Temperaturprofile durchläuft.

Vorzugsweise ist der Sinterzone eine Ausbrennzone zur Erreichung einer Temperatur von mindestens 500°C vorgeschaltet, in der die organischen Bestandteile der Metallpaste ausgebrannt werden können, so dass das Ausbrennen in die Produktionslinie integriert ist.

Ausbrenn- und Sinterzone können in einer Heizkassette, die mit Isolationskeramik ausgekleidet ist, integriert sein. Als Heizelemente werden vorzugsweise in an sich bekannter Weise Strahlungsheizungen eingesetzt. Die Kühlzonen können mit wassergekühlten Strahlungsabsorberblechen oder mit Konvektionskühlung durch Einblasen/Ansaugen von entsprechend temperiertem Inertgas, wozu hier auch gereinigt Luft geeignet ist, ausgebildet sein.

Die Heizelemente und Kühlelemente sind vorzugsweise rechnergesteuert, um das geforderte Temperaturprofil darzustellen und aufrechtzuerhalten.

Erfindungsgemäß kann die Entspannungszone, in der die schnelle Abkühlung für 10 bis 20 Sekunden unterbrochen wird, alternativ zu Heizelementen auch durch eine thermische Isolierung dargestellt werden, wobei lediglich die Eingangstemperatur in die Entspannungszone durch entsprechende Maßnahmen in der vorgeschalteten Kühlzone gesteuert wird.

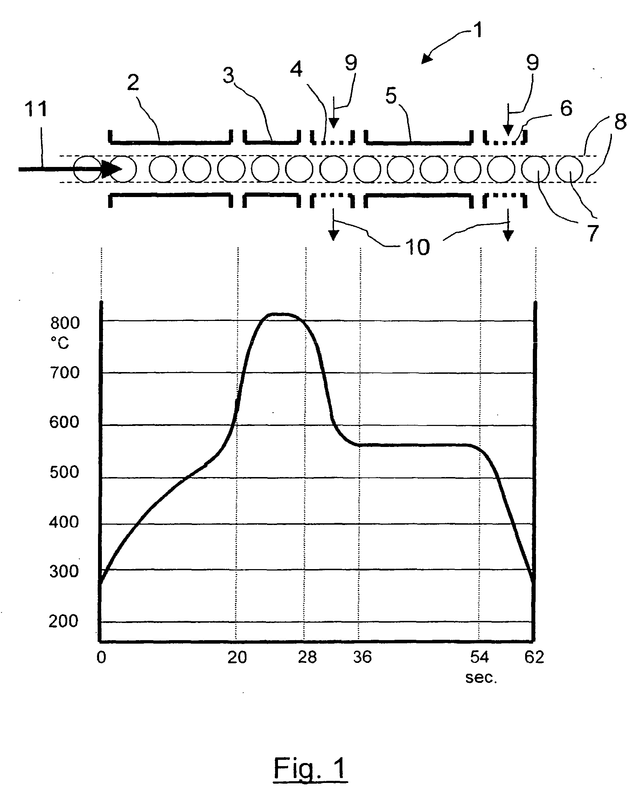

Die Erfindung wird nachfolgend anhand der Fig. 1 näher erläutert.

Fig. 1 zeigt im oberen Teil schematisch einen erfindungsgemäßen modularen Sinterofen 1 mit Ausbrennzone 2, Sinterzone 3, einer ersten schnellen Abkühlzone 4, einer Entspannungszone 5, in der die schnelle Abkühlung unterbrochen wird, sowie einer zweiten schnellen Abkühlzone 6. Mittels schematisch angedeuteter Transportmittel 8 werden ebenfalls schematisch angedeutete Siliziumwafer 7 in Richtung des Pfeils 11 durch den Durchlaufofen 1 transportiert. Typischerweise kann ein derartiger Durchlaufofen 1 wie dargestellt eine Gesamtlänge von 4 bis 12 m aufweisen.

Fig. 1 zeigt im unteren Teil ein zugehöriges erfindungsgemäßes Temperaturprofil des Ofens über einer beispielhaften Durchlaufzeit mit Zeitangaben in Sekunden. Die Zeitangaben entsprechen bei einer Länge des Ofens von 4 m einer Transportgeschwindigkeit von 6,45 cm/s = 4m/62s bzw. bei einer Länge vom 12 m einer Transportgeschwindigkeit von 19,4 cm/s = 12m/62s. Die Länge des Ofens bestimmt also die Durchsatzkapazität.

### Beispiel:

In einem Durchlauf-Sinterofen, wie in Fig. 1 dargestellt, wird eine Versuchsreihe durch Variation der Temperatur in der Entspannungszone 5 durchgeführt. Es werden 200µm dicke polykristalline Siliziumscheiben, die im Volumen mit 10¹⁶ Boratomen/cm³ dotiert waren und ferner einseitig mit einer Antireflexschicht aus Siliziumnitrid versehen waren, eingesetzt.
Die Siliziumscheiben wurden auf der nicht mit Antireflexschicht versehenen Seite ganzflächig mit Aluminiumpaste beschichtet.
Auf die bei der Solarzellenherstellung an sich erforderliche Phosphordotierung und Aufbringung einer streifenförmigen Silberpastenbeschichtung wurde verzichtet, um die Messung der Lebensdauer der Ladungsträger nicht zu stören. Nach Durchlauf durch den Sinterofen wurde durch µ-PCD-Messung die mittlere Ladungsträgerlebensdauer, beschrieben z.B. bei J. Schmidt und A.G.Aberle, J. Appl. Phys. 81, 6186, bestimmt. In Abhängigkeit von der Temperatur in der Entspannungszone ergaben sich die in Tabelle 1 dargestellten Ergebnisse.

**Tabelle 1:**

| Temperatur in der Entspannungszone °C | Mittlere Ladungsträgerlebensdauer *µ*s |
|---|---|
| 500 | 7,65 |
| 540 | 8,5 |
| 560 | 9,7 |
| 570 | 10,2 |
| 580 | 9,65 |
| 600 | 8,85 |

### Bezugszeichenliste

- 1: Sinterofen / Durchlaufofen
- 2: Ausbrennzone
- 3: Sinterzone
- 4: Abkühlzone
- 5: Entspannungszone
- 6: schnelle Abkühlzone
- 7: Siliziumwafer
- 8: Transportmittel
- 11: Pfeil

## Patentansprüche

1. Verfahren zur Herstellung von Siliziumsolarzellen durch Beschichten von vordotierten Siliziumwafern zumindest einseitig mit einer Aluminiumpaste, Zersetzen der organischen Pastenbestandteile und Kurzzeitsintern bei 700 bis 900°C mit schnellem Abkühlen auf eine Temperatur unter 300°C, **dadurch gekennzeichnet, dass** das schnelle Abkühlen in einem Temperaturbereich von 550 bis 600°C für 10 bis 20 Sekunden unterbrochen wird.

2. Verfahren nach Anspruch 1, **dadurch gekennzeichnet, dass** die Unterbrechung der schnellen Abkühlung im Temperaturbereich von 560 bis 590°C erfolgt.

3. Verfahren nach Anspruch 2, **dadurch gekennzeichnet, dass** die Unterbrechung der schnellen Abkühlung im Temperaturbereich von 570 bis 580°C erfolgt.

4. Verfahren nach einem der Ansprüche 1 bis 3, **dadurch gekennzeichnet, dass** das schnelle Abkühlen nach dem Sinterschritt bei einer Abkühlgeschwindigkeit von mehr als 20°C pro Sekunde erfolgt.

5. Mehrstufiger Durchlauf-Sinterofen für die Kontaktierung von Siliziumwafern mit folgenden Elementen:
a) einer Sinterzone zur Erreichung einer Temperatur von 700 bis 900°C;
b) einer sich an die Sinterzone anschließende erste Kühlzone zur Abkühlung auf eine Temperatur zwischen 550 bis 600°C;
c) einer sich an die erste Kühlzone anschließende Entspannungszone, eingerichtet zur Aufrechterhaltung einer Temperatur von 550 bis 600°C;
d) einer sich an die Entspannungszone anschließende zweite Kühlzone zur Erreichung einer Temperatur von unterhalb 300°C;
wobei die Länge in Durchgangsrichtung der Entspannungszone das 1,5- bis 4,5-fache der Länge der Sinterzone beträgt; und
wobei die Länge in Durchgangsrichtung der ersten Kühlzone das 0,7- bis 2-fache der Sinterzone beträgt.

6. Sinterofen nach Anspruch 5, **dadurch gekennzeichnet, dass** einzelne Zonen als Module ausgebildet sind.

7. Sinterofen nach Anspruch 5 oder 6, **dadurch gekennzeichnet, dass** der Sinterzone eine Ausbrennzone zur Erreichung einer Temperatur von mindestens 500°C vorgeschaltet ist.

8. Sinterofen nach einem der Ansprüche 5 bis 7, **dadurch gekennzeichnet, dass** das Temperaturprofil über die verschiedenen Zonen durch rechnergesteuerte Heizelemente und Kühlelemente einstellbar ist.

9. Sinterofen nach einem der Ansprüche 5 bis 8, **dadurch gekennzeichnet, dass** die Heizung in der Sinterzone durch Wärmestrahler erfolgt.

10. Sinterofen nach einem der Ansprüche 5 bis 9, **dadurch gekennzeichnet, dass** das Temperaturprofil in der Entspannungszone durch eine geeignete thermische Isolierung bewirkt ist.

11. Sinterofen nach einem der Ansprüche 5 bis 10, **dadurch gekennzeichnet, dass** das Temperaturprofil in den Kühlzonen durch gezieltes Einblasen bzw. Absaugen von Inertgas einschließlich gereinigter Luft erzeugt wird.

## Claims

1. Method for production silicon solar cells by coating predoped silicon wafers at least on one side with an aluminium paste, decomposition of the organic paste components and short-term sintering at a temperature of 700 to 900°C with a rapid cooling to a temperature below 300°C,
**characterized in that**
the rapid cooling is interrupted in a temperature range of 550 to 600°C for 10 to 20 seconds.

2. Method according to claim 1,
**characterized in that**
the interruption of the rapid cooling is carried out in a temperature range from 560 to 590°C.

3. Method according to claim 2,
**characterized in that**
the interruption of the rapid cooling is carried out in a temperature range from 570 to 580°C.

4. Method according to any of the claims 1 to 3,
**characterized in that**
the rapid cooling after the sintering step is carried out at a cooling rate of more than 20°C pro second.

5. Multi-stage furnace for continuous sintering for the metallization of silicon wafers with the following elements:
a) a sintering area for reaching a temperature of 700 to 900°C;
b) a first cooling area following the sintering area for cooling to a temperature between 550 and 600°C;
c) a relaxation area following the first cooling area adjusted for maintaining a temperature from 550 to 600°C;
d) a second cooling area following the relaxation area for reaching a temperature lower than 300°C,
whereby the length in the direction of passage of the relaxation area is 1,5 to 4,5 times the length of the sintering area and
whereby the length in the direction of passage of the first cooling is 0,7 to 2 times the length of the sintering area.

6. Sintering furnace according to claim 5,
**characterized in that**
single areas are configured as modules.

7. Sintering furnace according to claim 5 or 6,
**characterized in that**
a burn-out area is preceding the sintering area for reaching a temperature of at least 500°C.

8. Sintering furnace according to any of the claims 5 to 7,
**characterized in that**
the temperature profile is adjustable over the different areas by computer controlled heating elements or cooling elements.

9. Sintering furnace according to any of the claims 5 to 8,
**characterized in that**
the heating in the sintering area is carried out by heat radiators.

10. Sintering furnace according to any of the claims 5 to 9,
**characterized in that** the temperature profile in the relaxation area is caused by an appropriate thermal insulation.

11. Sintering furnace according to any of the claims 5 to 10,
**characterized in that**
the temperature profile in the cooling areas is generated by insufflating or sucking off inert gas including purified air.

## Revendications

1. Procédé de fabrication de cellules solaires en silicium par revêtement de wafers de silicium préalablement dopés au moins sur un côté avec une pâte d'aluminium, décomposition des composants organiques de la pâte et frittage de courte durée à une température de 700 à 900°C avec refroidissement rapide à une température inférieure à 300°C,
**caractérisé en ce**
**que** le refroidissement rapide est interrompu dans une plage de température de 550 à 600°C pendant 10 à 20 secondes.

2. Procédé selon la revendication 1,
**caractérisé en ce**
**que** l'interruption du refroidissement rapide est effectuée dans la plage de température de 560 à 590°C.

3. Procédé selon la revendication 2,
**caractérisé en ce**
**que** l'interruption du refroidissement rapide est effectuée dans la plage de température de 570 à 580°C.

4. Procédé selon l'une des revendications 1 à 3,
**caractérisé en ce**
**que** le refroidissement rapide est effectué après l'étape de frittage à une vitesse de refroidissement de plus de 20°C par seconde.

5. Four continu de frittage à plusieurs étages pour la métallisation de wafers de silicium avec les éléments suivants :
a) une zone de frittage pour atteindre une température de 700 à 900°C;
b) une première zone de refroidissement qui suit la zone de frittage pour le refroidissement à une température de 550 à 600°C;
c) une zone de relaxation, qui suit la première zone de refroidissement, réglée pour maintenir une température de 550 à 600°C;
d) une seconde zone de refroidissement qui suit la zone de relaxation pour atteindre une température inférieure à 300°C,
la longueur dans le sens de passage de la zone de relaxation étant de 1,5 fois à 4,5 fois la longueur de la zone de frittage et
la longueur dans le sens de passage de la première zone de refroidissement étant de 0,7 fois à 2 fois la longueur de la zone de frittage.

6. Four de frittage selon la revendication 5,
**caractérisé en ce**
**que** des zones individuelles sont configurées comme des modules.

7. Four de frittage selon la revendication 5 ou 6,
**caractérisé en ce**
**qu'**une zone de combustion est placée en amont de la zone de frittage pour atteindre une température d'au moins 500°C.

8. Four de frittage selon l'une des revendications 5 à 7,
**caractérisé en ce**
**que** le profil de température est réglable sur les différentes zones par des éléments de chauffage et des éléments de refroidissement commandés par ordinateur.

9. Four de frittage selon l'une des revendications 5 à 8,
**caractérisé en ce**
**que** le chauffage est effectué dans la zone de frittage par des radiateurs thermiques.

10. Four de frittage selon l'une des revendications 5 à 9,
**caractérisé en ce**
**que** le profil de température dans la zone de relaxation est causé par une isolation thermique appropriée.

11. Four de frittage selon l'une des revendications 5 à 10,
**caractérisé en ce**
**que** le profil de température dans les zones de refroidissement est produit par l'insufflation ou l'aspiration ciblée de gaz inerte, y compris d'air purifié.
